# EUROPEAN PATENT APPLICATION

(11) **EP 1 862 726 A1**
(43) Date of publication of application: **05.12.2007**
(21) Application number: 05729124.7
(22) Date of filing: 21.03.2005
(51) Int. Cl.: F21S 4/00

(54) **A FLEXIBLE TUBULAR LIGHT WITH FLOWING FLICKER EFFECT**

(71) Applicant: He Shan Lide Electronic Enterprise Company Ltd, Guandong 529728 (CN)
(72) Inventor: FAN, BangHong, Heshan, Guangdong 529728 (CN)
(74) Representative: Mittler, Enrico
(86) International application number: PCT/CN2005/000344
(87) International publication number: WO 2006/099773

(57) **Abstract**

A flexible tubular light having the flowing flash effect includes a transparent inner cladding layer and a plurality of PCBs that are connected with each other in series and are provided within the through-hole of the inner cladding layer. Each PCB is provided with a plurality of LEDs, corresponding quantity of current limiting resistors and chips for driving the LEDs. The PCBs are connected in parallel with the copper strands of the inner cladding layer. The signal wires of the LED driving chips are connected in series with a controller. A transparent outer cladding layer encloses the inner cladding layer. The LED driving chip comprises serial shift registers and output registers, and adopts cascade connection and three high current output signals. The PCBs are provided with main wires, and the main wires of the two adjacent PCBs are connected in parallel. The flexible tubular light having the flowing flash effect realizes the signal regeneration, signal cascade connection and signal transmission without limit, and can be bended and cut. [FIG.2]

## Description

### BACKGROUND OF THE INVENTION

The present invention relates to providing a kind of decorative lighting device. More particularly, the present invention is a flexible tubular light with the flowing flash effect.

In the prior art, it is very common that the function of digital control display is used in screen, especially in large screen formed of light-emitting diodes (LED). These devices display various images and characters, and realize the effects including movement, chase, etc on the screen by circuit control. However, this can only be used in large screen in which an image is constructed by scanning the rows and columns. As for a small screen or a linear structure, the above-mentioned effects can not be obtained. Therefore, a LED tube light is developed in which the screen module is simplified into linear type, and packaged in a translucent rigid tube. But this type of tube light can not be bended or cut, and the signal control wire adopts parallel interface, the I/O interface of the main MCU is TTL electrical level interface, which is not adapted for long distance transmission. Moreover, the LED driving chip can not be used for cascade connection, that is to say, a signal can not be transmitted along the same main signal wire without limit.

The common features between the above-mentioned screen and the above-mentioned tube light lie in that: the on/off and light emitting state of each LED illuminant, i.e. the pixel, is controlled by the main MCU and the LED driving chip, and the cascade connection of signal can not be realized. With the rapid development of LED illumination technology, the power LED is developed, and more application fields of the LED begin to be developed. In order to enable the bending and cutting mentioned above, people begin to try to apply the function of digital control display to the field of flexible tubular light, and try to realize the cascade connection and regeneration of signal.

A flexible screen of LED is disclosed in Chinese Patent No. 200320128741.5. In this patent, a plurality of units is provided with LEDS and forms a flexible screen. However, the cascade connection and regeneration of signal are not mentioned. In fact, the cascade connection, regeneration and transmission without limit of signal can not be obtained in this patent. In addition, the flowing flash effect can not be realized in this patent either.

The visual effects such as infinite variety and shining appearance are sought in the field of flexible tubular light. Neither the duralight with brilliant effect nor the flexible neon light with uniform, sequential, vivid and soft effect can be flexibly controlled in respect of the light emitting, in other words, the chase effect among the plurality of the units may be realized in a light strip, but the chase effect among different LED illuminants, that is to say, the flowing flash effect can not be obtained. In order to obtain the flowing flash effect, the on/off state of each LED illuminant should be controlled independently, thus a large amount of circuits should be added into the known flexible tubular light i.e. duralight or flexible neon light, which results in the increasing size of the known flexible tubular light. Obviously, the flexible tubular light would lose the decorative function and the applicability accordingly.

Therefore, in market, it is desired that a flexible tubular light having digital controlling display function can be controlled in respect of the on/off state of each LED illuminant, and has the flowing flash effect that the light beams of the LED illuminants chase each other, and can realize the regeneration, cascade connection and transmission without limit of signal, and can be bended and cut.

### SUMMARY OF THE INVENTION

Having outlined the state of the prior art and its attendant shortages, it is the object of the present invention to provide a flexible tubular light having digital controlling display function which can be controlled in respect of the on/off state of each LED illuminant, and has the flowing flash effect that the light beams of the LED illuminants chase each other, and can realize the regeneration, cascade connection and transmission without limit of signal, and can be bended and cut.

To attain the above-described object, the present invention provides a flexible tubular light with flowing flash effect comprising:
a transparent inner cladding layer, the inner cladding layer being a strip-shaped member formed of flexible transparent plastic by extrusion molding, the strip-shaped member being provided with a through hole extending longitudinally inside, two copper strands extending longitudinally in the sidewall of the strip-shaped member and having the same length as the inner cladding layer, an open slot being formed longitudinally along the midline of the lower sidewall of the inner cladding layer;
a plurality of printed circuit boards, each printed circuit board being provided with a plurality of LEDS, corresponding quantity of series limiting resistors and a LED driving chip, each printed circuit board being provided with wires at the two ends, the printed circuit boards being connected with each other in series by the wires, the power supply cords of the printed circuit boards being connected to the copper strands in parallel, the signal wires of the printed circuit boards being connected with a controller in series, the signal wires of the LED driving chip being connected with the controller in series, the printed circuit boards being disposed in the through hole of the inner cladding layer;
a transparent outer cladding layer for enclosing the inner cladding layer and the plurality of printed circuit boards , the outer cladding layer having the same length as the inner cladding layer being formed of flexible transparent plastic by extrusion molding.

The LED driving chip is a chip supplying three high current output signals and allows cascade connection, and includes serial shift registers and output registers.

The printed circuit board is provided with main wires in which the main wires of two adjacent printed circuit boards are connected with each other by wires in parallel.

The printed circuit board is further provided with capacitors and voltage-stabilized resistors.

The LED driving chip is a chip made by adopting CMOS with low power consumption and I high noise immunity.

The LED is a surface mounted type LED.

The LED is a normal LED having flat and cubic package colloid.

The LED is a R-G-B LED.

Compared with the prior art, the advantages of the flexible tubular light of the present invention are: owing to that printed circuit boards (PCB) are provided in the flexible tube and LED driving chips are provided on the PCBs, the on/off state of each LED illuminant can be controlled, and the flowing flash effect that the light beams of the LED illuminants chase each other is obtained, and moreover the flexible tubular light is provided with a main controller by which the visual effects such as infinite variety and shining appearance can be realized; owing to the LED driving chip includes serial shift registers and output registers, the regeneration, cascade connection and transmission without limit of signal are obtained; owing to that a flexible tube is used for preparing the light belt, and each of the power cords of PCB is in parallel with the copper strands in the inner cladding layer, and that the main wires of every two adjacent PCBs are in parallel with each other, the flexible tubular light according to the present invention can be bended, and can be cut at the position where the power cords of the two adjacent PCBs connect with each other; moreover, the using of flexible tube allows the flexible tubular light to be very convenient for transport, assembly and decoration. Accordingly, the flexible tubular light having various decorative effects can be widely used in decorative lights and capable to be controlled freely.

### BRIEF DESCRIPTION OF THE DRAWINGS

The structural and operational characteristics of the present invention will be better understood from the following description, relating to the attached drawings that show illustratively but not restrictively examples of the invention. In the drawings:
FIG. 1 is a schematic view showing the appearance of a flexible tubular light according to an embodiment of the present invention;
FIG. 2 is a schematic perspective view of the flexible tubular light;
FIG. 3 is a detailed view of the portion "A" as shown in FIG. 2;
FIG. 4 is a schematic view of an inner cladding layer;
FIG. 5 is a structural view of the connection between the PCBs;
FIG. 6 is a circuit diagram of the flexible tubular light according to an embodiment of the present invention;
FIG. 7 is a schematic view of a flexible tubular according to another embodiment of the present invention;
FIG. 8 is a sectional view of a known duralight; and
FIG. 9 is a schematic view of an example of the flexible tubular lights in use, according to an embodiment of the present invention.

### DETAILED DESCRIPTION OF THE PREFERRED EMBODIMENT

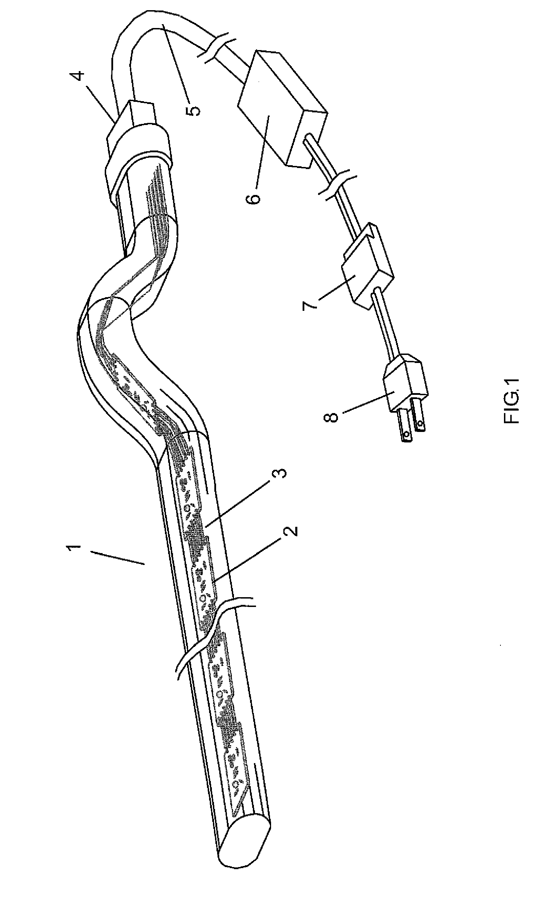

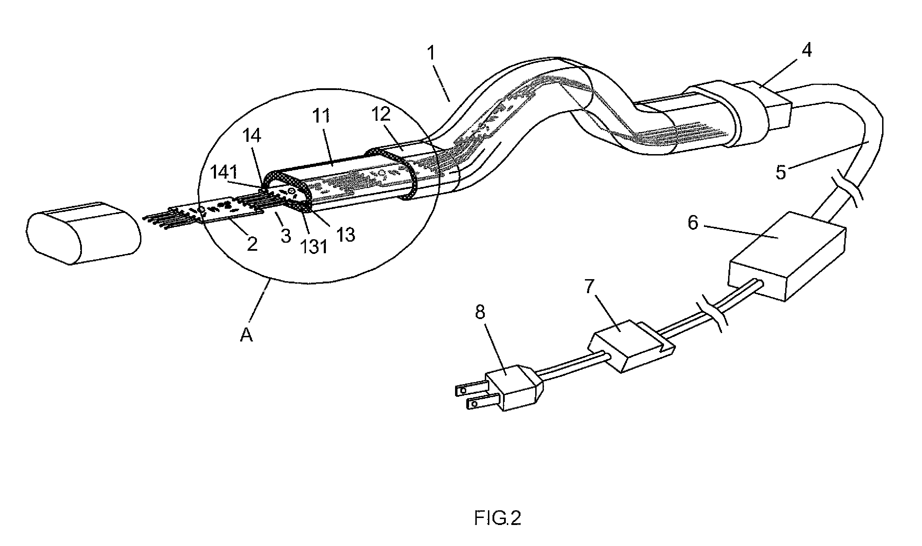

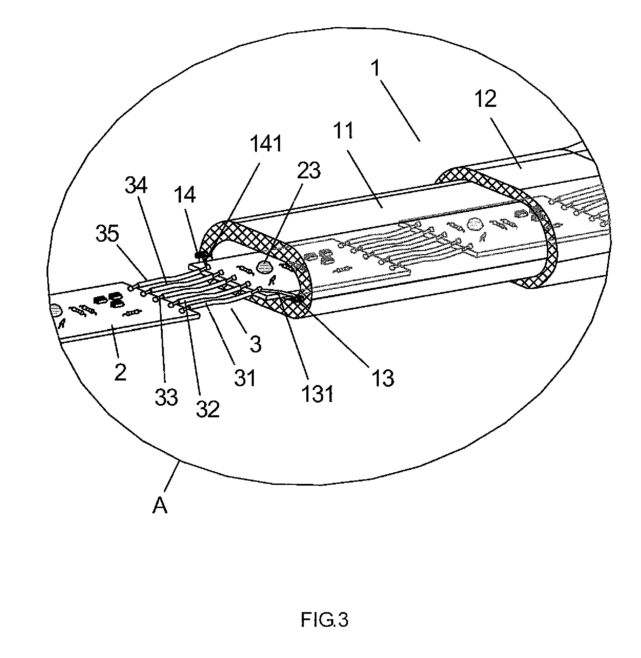

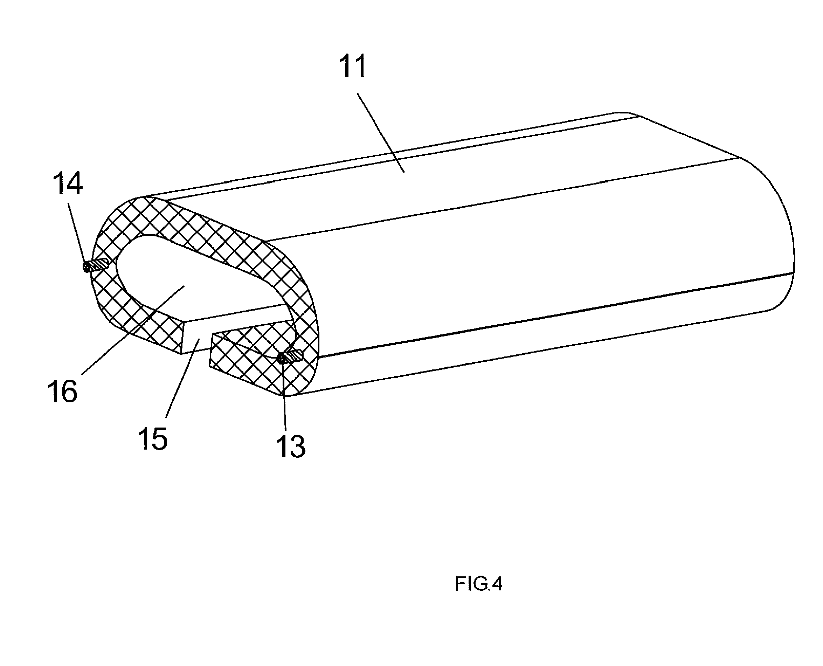

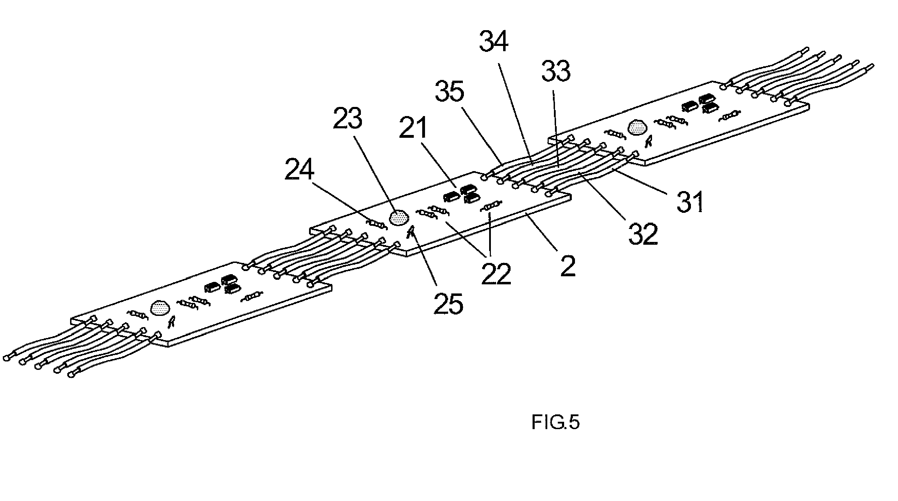

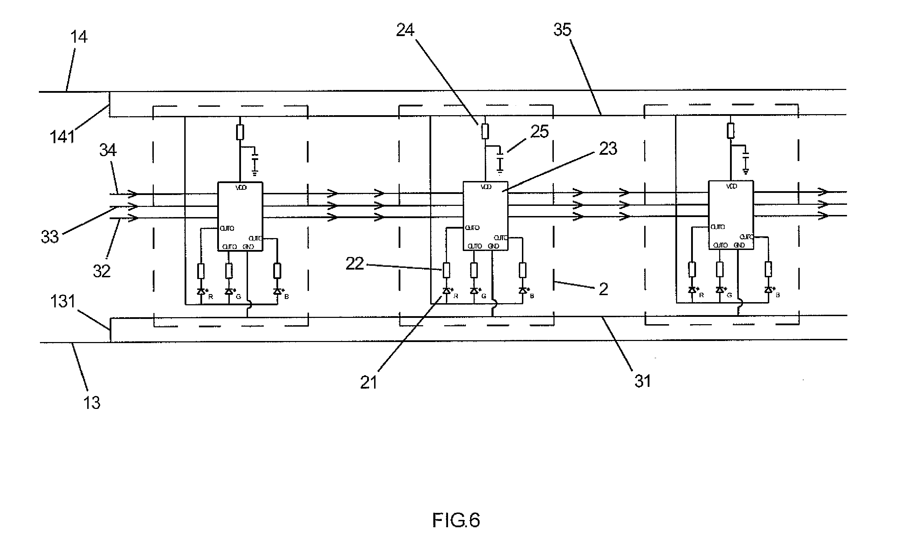

Referring to FIGS. 1, 2 and 3, a flexible tubular light mainly comprises an inner cladding layer 11, PCBs 2, an outer cladding layer 12, a connector 4, a connecting wire 5, a controller 6, a switching power supply 7, and a plug 8. The inner cladding layer 11 and the outer cladding layer 12 forms a casing 1 of the light. The inner cladding layer 11 is a strip-shaped member formed of flexible transparent plastic by extrusion molding, as shown in FIG. 4, the strip-shaped member has a through hole extending longitudinally inside. The strip-shaped member is provided in the sidewall with two copper strands 13, 14 extending longitudinally. The two copper strands 13, 14 are of the same length as the inner cladding layer 11. Moreover, an open slot 15 is formed longitudinally along the midline of the lower sidewall of the inner cladding layer 11. As shown in FIG. 5, the PCBs are connected with each other in series, and the connected PCBs are inserted into the inner cladding layer via the open slot 15. Each PCB 2 is provided with a plurality of LED illuminants 21, corresponding quantity of series current limiting resistors 22 and a chip 23 for driving the LEDs. In this embodiment, a basic unit is formed of three LED illuminants, three series current limiting resistors and a chip 23 for driving the LED illuminants. Two or more basic units may be arranged so as to obtain the desired density of the LED illuminants. Each PCB is provided with wire bundles 3 on the two ends, as shown in FIG.1. The wire bundle 3 consists of wires31, 32, 33, 34 and 35, as shown in FIG. 5, wherein the wires 31 and 35 are power connecting wires, the wires 32, 33 and 34 are signal wires, the wire 32 is a clock signal (CLK) wire, the wire 33 is an output enable signal (EN) wire, the wire 34 is a data signal wire. The PCBs are connected with each other in series by these wires. Each PCB 2 is provided with main wires. The main wires of each two adjacent PCBs are connected with each other by the power connecting wires 31 and 35 such that the main wires of each two adjacent PCBs are in parallel connection. The main wires after being in parallel with the power connecting wires 31 and 35 are connected to the copper strands 13 and 14 in the inner cladding layer 11. As shown in FIG. 3 and 6, the power connecting wire 31 is connected to the copper strand 13 by a wire 131, and the power connecting wire 35 is connected to the copper strand 14 by a wire 141. The signal wires of the driving chip 23 on each PCB 2 are connected with each other in series by signal connecting wires 32, 33 and 34, and connected to the controller 6 by the connector 4 and the connecting wire 5. The connector 4 is a connector with multi-pins and multi-orifices. The connecting wire 5 consists of signal connecting wires and power connecting wires. In order to stabilize the light emitted by the LED illuminant 21 and increase the lifetime of the LED, the printed circuit board may be further provided with a capacitor 25 and a voltage-stabilized resistor 24. The circuit portion formed of the voltage-stabilized resistor 24 and the capacitor 25 can be of the functions including voltage stabilization and protection. All the connected PCBs and the wires are inserted into the through hole 16 of the inner cladding layer 11 via the open slot 15 at the lower sidewall of the inner cladding layer 11. Finally, an outer cladding layer 12 is formed of flexible transparent plastic by extrusion molding for wrapping the inner cladding layer 11 and the PCBs contained therein. The outer cladding layer 12 has the same length as the inner cladding layer 11, and constructs the casing 1 of the light.

FIG. 6 is a circuit diagram of the flexible tubular light according to an embodiment of the present invention. The LED driving chip 23 can be a chip supplying three high current output signals and allows cascade connection. The chip includes a serial shift register and an output register, and is made by adopting CMOS, and is of high noise immunity and low power consumption. The regulated DC power supply is supplied to the copper strands 13 and14 by the switching power supply 7, and thus the same regulated DC power supply is obtained on the main wire of each PCB. After signal is transmitted to the LED driving chip of the first PCB, the data signal is transmitted to the input end of the serial shift register, after which the serial input is converted into two signal outputs. One of the two signal outputs is 3bit parallel signal output, which, after being driven, supplies three currents for driving three LEDs on the first PCB. The other one of the two signal outputs is transmitted to the latter-stage circuit by the output register. The serial register and the output register are controlled by clock signal, and active on the rising edge of the clock signal. The control signal is driven by the chip and then transmitted to the LED illuminants. The control signal driven by the chip is also used as the input signal of the latter-stage circuit in which the input signal is regenerated by the regulated DC power supply in parallel with the pre-stage circuit. Then, the input signal is transmitted to the LED illuminant by the driving chip and to the next-stage circuit. In this process, the whole circuit allows the increase, regeneration and cascade connection of the signals, so that the signal can be transmitted infinitely.

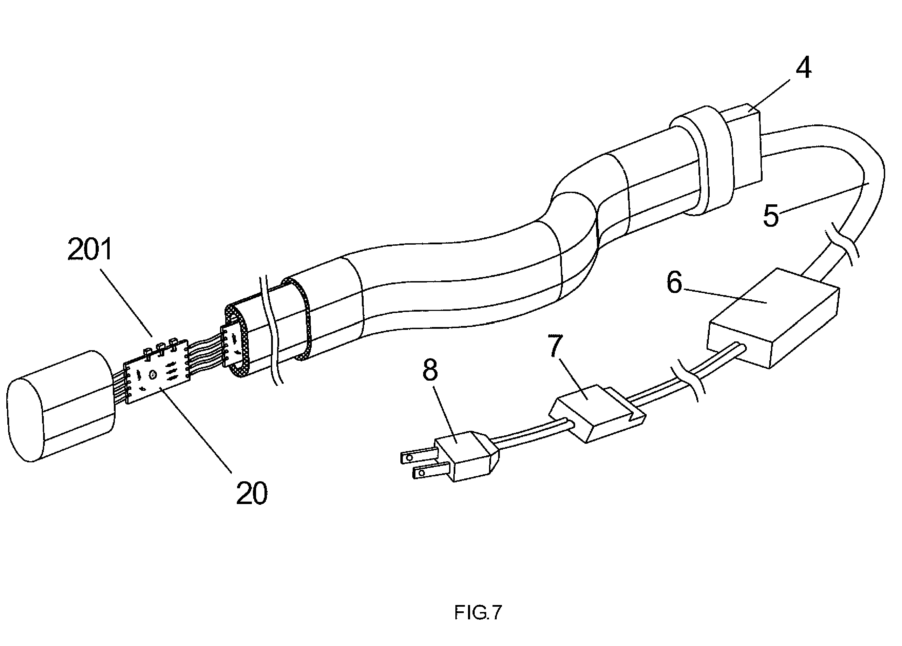

The LED illuminant may be a surface mounted type LED, a normal LED having flat and cubic package colloid or a RGB LED. Furthermore, in order to allow the flexible tubular light to be vertical and curved when being assembled on a plane, another embodiment may be implemented, as shown in FIG. 7. In this embodiment, the PCB 20 is arranged vertically, the LED illuminant on the PCB 20 is a normal LED 201 having flat and cubic package colloid, the two pins of the LED 201 are bended 90°upwards after the LED 201 is soldered to the PCB 20 such that the LED 201 is upright, as shown in FIG.7, and therefore the vertical curved shape is obtained while the light emitting surface of the LED201 is upward.

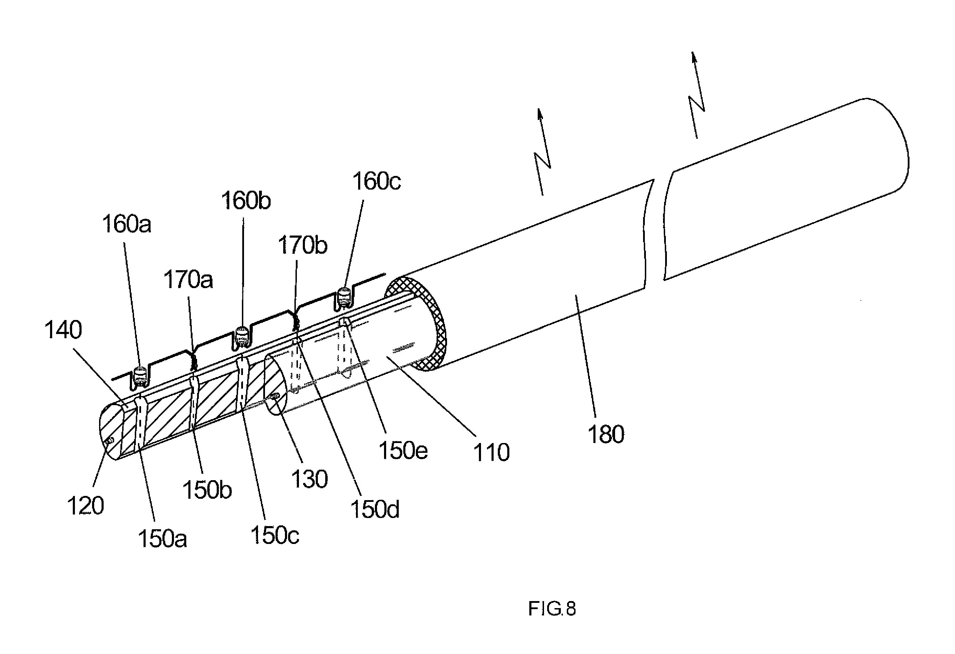

FIG. 8 is a sectional view of a known duralight. The strip-shaped transparent plastic core 110 is longitudinally provided with at least two wires 120 and 130, and is provided with a longitudinal groove 140 or a plurality of lateral holes 150a, 150b, 150c, 150d and 150e, for containing a plurality of light bulbs 160a, 160b and 160c and the connecting wires 170a and 170b thereof. The light bulbs is connected to the connecting wires after being in series with each other, and then the transparent plastic core is enclosed in a transparent plastic cladding layer 180.

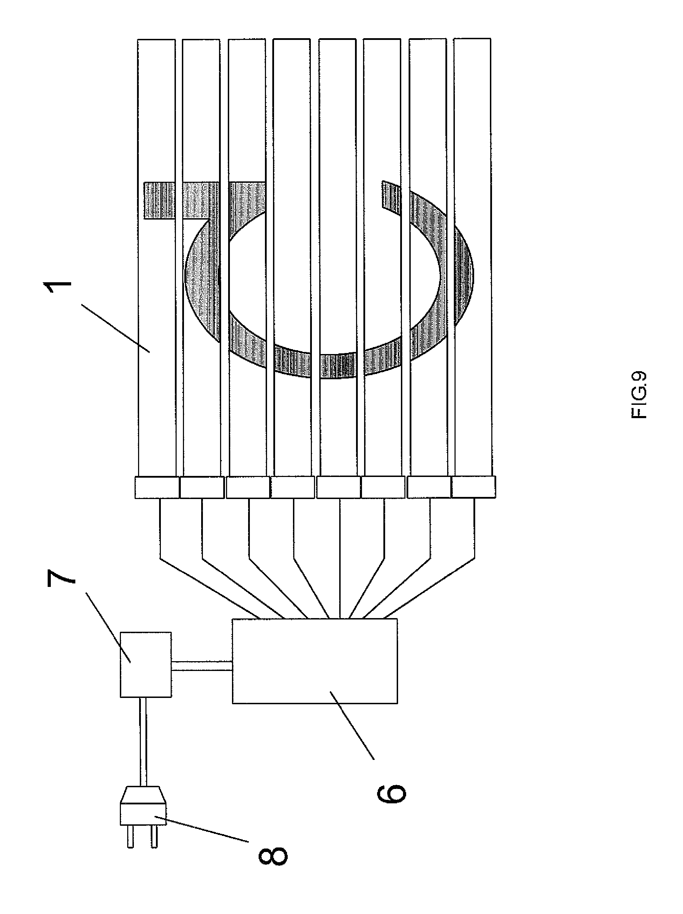

FIG. 9 is a schematic view of an example of the flexible tubular lights in use. One flexible tubular light or a plurality of flexible tubular lights in parallel with each other can be used for decoration and bring light flowing effect. By assembling the plurality of flexible tubular lights 1 in parallel, as shown in FIG. 9, the plurality of flexible tubular lights 1 can form various images or characters and bring light flowing effect, by controlling the signals of the controller 6, for example, as shown in FIG. 9, the character "C" is displayed by the parallel flexible tubular lights.

With the flexible tubular light according to the present invention, the signal regeneration and cascade connection, the signal transmission without limit and the visual effect of light flowing are obtained. The flexible tubular is of wonderful, shining, flexible and various decoration results accordingly. The flexible tubular light according to the present invention can be bended, and cut at the joint portion where the main wires are connected to the copper strands in parallel, and can be extended by connecting with other flexible tubular light.

Although the present invention has been described in connection with preferred embodiment thereof, many other variations and modifications will now become apparent to those skilled in the art without departing from the scope of the invention. It is preferred, therefore, that the present invention should not be limited by the specific disclosure herein, but only by the appended claims.

## Claims

1. A flexible tubular light with flowing flash effect, comprising:
a transparent inner cladding layer, the inner cladding layer being a strip-shaped member formed of flexible transparent plastic by extrusion molding, the strip-shaped member being provided with a through hole extending longitudinally inside, two copper strands extending longitudinally in the sidewall of the strip-shaped member and having the same length as the inner cladding layer, an open slot being formed longitudinally along the midline of the lower sidewall of the inner cladding layer;
a plurality of printed circuit boards, each printed circuit board being provided with a plurality of LEDs, corresponding quantity of series limiting resistors and a LED driving chip, each printed circuit board being provided with wires at the two ends, the printed circuit boards being connected with each other in series by the wires, the power supply cords of the printed circuit boards being connected to the copper strands in parallel, the signal wires of the printed circuit boards being connected with a controller in series, the signal wires of the LED driving chip being connected with the controller in series, the printed circuit boards being disposed in the through hole of the inner cladding layer;
a transparent outer cladding layer for enclosing the inner cladding layer and the plurality of printed circuit boards , the outer cladding layer having the same length as the inner cladding layer being formed of flexible transparent plastic by extrusion molding.

2. The flexible tubular light with flowing flash effect of claim 1, wherein said LED driving chip is a chip supplying three high current output signals and allows cascade connection, and includes serial shift registers and output registers.

3. The flexible tubular light with flowing flash effect of claim 1, wherein said printed circuit board is provided with main wires, the main wires of each two adjacent printed circuit boards are connected with each other by wires in parallel.

4. The flexible tubular light with flowing flash effect of claim 1, wherein said printed circuit board is further provided with capacitors and voltage-stabilized resistors.

5. The flexible tubular light with flowing flash effect of claim 1, wherein said LED driving chip is a chip with low power consumption and high noise immunity made by adopting CMOS.

6. The flexible tubular light with flowing flash effect of claim 1, wherein said LED is a surface mounted type LED.

7. The flexible tubular light with flowing flash effect of claim 1, wherein the LED is a normal LED having flat and cubic package colloid.

8. The flexible tubular light with flowing flash effect of claim 1, wherein said LED is a RGB LED.
